# EUROPEAN PATENT APPLICATION

(11) **EP 2 256 171 A1**
(43) Date of publication of application: **01.12.2010**
(21) Application number: 10009005.9
(22) Date of filing: 27.07.2004
(51) Int. Cl.: C09G 1/02, C09G 1/04, B24B 1/00, C01G 39/02, C23F 3/04, H01L 21/321

(54) **Methods for chemical-mechanical planarization of copper**

(30) Priority: 30.07.2003 US 631698; 13.05.2004 US 846718
(62) Divisional of application: 04779276.7
(71) Applicant: Climax Engineered Materials, LLC, Phoenix, AZ 85004-2306 (US)
(72) Inventor: Babu, S.,V., Potsdam, NY 13676 (US); Hedge, Sharath, Potsdam, NY 13676 (US); Jha, Sunil, Oro Valley, AZ 85737 (US); Patri, Udaya, B., Potsdam,NY 13676 (US); Hong, Youngki, Potsdam, NY 13676 (US)
(74) Representative: Tönhardt, Marion

(57) **Abstract**

A method for chemical-mechanical planarization of a copper layer, comprising:
providing an aqueous slurry comprising particles of MoO₂ having a mean particle size in a range from 100 nm to 1000 nm in a solution of deionized water and an oxidizing agent; and
polishing the copper layer using the aqueous slurry and a polishing pad.

## Description

### Technical Field

This invention relates to chemical-mechanical planarization processes in general and more specifically to a molybdenum oxide slurry and method for the chemical-mechanical planarization of copper.

### Background

Chemical-mechanical planarization (CMP) is the term used to refer to a process that is used in manufacturing semiconductors. As its name implies, the CMP process is typically used in semiconductor processing to polish (e.g., planarize) the surface of the semiconductor wafer. The CMP process is relatively new in that, until recently, conventional processes were sufficient with the comparatively low circuit densities involved. However, increases in circuit densities (e.g., the transition from wafers having 0.25 micron features to 0.18 micron features) have forced the need to develop new processes for planarizing the wafer, of which CMP has become favored. Similarly, the more recent shift away from aluminum interconnect technology to copper interconnect technology has further favored the use of CMP to polish (e.g., planarize) semiconductor wafers.

Briefly, the chemical-mechanical planarization (CMP) process involves scrubbing a semiconductor wafer with a pad in the presence of a chemically reactive slurry that contains abrasive particles. As its name implies, the planarization action of the chemical-mechanical planarization (CMP) process is both chemical and mechanical. Chemicals aid in material removal by modifying the surface film while abrasion between the surface particles, pad, and the modified film facilitates mechanical removal. It is believed that this synergistic interplay between the chemical and mechanical components in the process is the key to the effective planarization of the CMP process.

While the CMP process is being increasingly used in semiconductor manufacturing processes, the CMP process remains poorly understood, and the exact mechanisms though which the process works have not been determined. For example, while certain parameters for the CMP process have been developed that are satisfactory for wafers utilizing aluminum interconnect technology, those same process parameters have not proven to be particularly satisfactory for use with wafers utilizing copper interconnect technology. One important requirement of a successful CMP slurry for copper is a high polish rate. High polish rates lead to shorter copper overburden planarization times.

### Summary of the Invention

The following summary is provided as a brief overview of the claimed product and process. It shall not limit the invention in any respect, with a detailed and fully-enabling disclosure being set forth in the Detailed Description of Preferred Embodiments section. Likewise, the invention shall not be restricted to any numerical parameters, processing equipment, chemical reagents, operational conditions, and other variables unless otherwise stated herein.

The claimed invention involves a novel aqueous planarization slurry for chemical-mechanical planarization that is effective for planarizing copper at high polish rates. The aqueous slurry according to the present invention comprises particles of MoO₃ dissolved in an oxidizing agent.

Embodiments of aqueous slurries may contain dissolved MoO₃ in amounts ranging from about 0.1 % to about 10 % by weight of MoO₃ and the oxidizing agent may comprise any one or a mixture of hydrogen peroxide (H₂O₂), ferric nitrate (Fe(NO₃)₃), potassium iodate (KIO₃), nitric acid (HNO₃), potassium permanganate (KMnO₄), potassium persulfate (K₂S₂O₈), ammonium persulfate ((NH₄)₂S₂O₈), potassium periodate (KIO₄), and hydroxylamine (NH₂OH). Additionally, complexing agents may be used in the molybdenum trioxide (MoO₃) aqueous slurry. Complexing agents may comprise any one or a mixture of glycine (C₂H₅NO₂), alanine (C3H₇NO₂), amino butyric acids (C₄H₉NO₂) ethylene diamine (C₂H₈N₂), ethylene diamine tetra acetic acid (EDTA), ammonia (NH₃), family of mono, di, and tri-carboxylic acids like citric acid (C₆H₈O₇), phthalic acid (C₆H₄(COOH)₂), oxalic acid (C₂H₂O₄), acetic acid (C₂H₄O₂), succinic acid (C₄H₆O₄), and family of amino benzoic acids.

Embodiments of slurries containing molybdenum trioxide (MoO₃) may also be provided with a nonionic surfactant, an anionic surfactant, or a cationic surfactant. The anionic surfactant in the aqueous slurry may comprise any one or a mixture of polyacrylic acid (PAA), a carboxylic acid or its salt, a sulfuric ester or its salt, a sulfonic acid or its salt, a phosphoric acid or its salt, and a sulfosuccinic acid or its salt. The cationic surfactant in the aqueous slurry may comprise any one or a mixture of a primary amine or its salt, a secondary amine or its salt, a tertiary amine or its salt, and a quaternary amine or its salt. The nonionic surfactant may comprise any one or a mixture of one of many polyethylene glycols.

Still yet other embodiments of aqueous slurries may be provided with a copper corrosion inhibitor which may comprise any one or a mixture of heterocyclic organic compounds including benzotriazole (BTA), benzimidazole, poly triazole, phenyl triazole, thion and their derivatives. Further embodiments of slurries may contain any combination of these surfactants and corrosion inhibitors.

Aqueous slurries may optionally include acids or bases for adjusting the pH within an effective range from about 1 to about 14. Yet additional embodiments of slurries according to the invention may also be provided with supplemental ceramic/metal oxide particles. Such supplemental ceramic/metal oxide particles used in the aqueous slurry may comprise any one or a mixture of silica, ceria, aluminia, zirconia, titania, magnesia, iron oxide, tin oxide, and germania.

The present invention also includes a novel method of planarizing copper by chemical-mechanical planarization. The method of the present invention comprises planarizing copper using a polishing pad and an aqueous slurry comprising dissolved MoO₃ particles and an oxidizing agent.

Embodiments of the method of planarizing copper using a slurry may contain MoO₃ in amounts ranging from about 0.1 % to about 10 % by weight of MoO₃ and the oxidizing agent may comprise any one or a mixture of hydrogen peroxide (H₂O₂), ferric nitrate (Fe(NO₃)₃), potassium iodate (KIO₃), nitric acid (HNO₃), potassium permanganate (KMnO₄), potassium persulfate (K₂S₂O₈), ammonium persulfate ((NH₄)₂S₂O₈), potassium periodate (KIO₄), and hydroxylamine (NH₂OH). Additionally, complexing agents may be used in the molybdenum trioxide (MoO₃) aqueous slurry. Complexing agents may comprise any one or a mixture of glycine (C₂H₅NO₂), alanine (C₃H₇NO₂), amino butyric acids (C₄H₉NO₂), ethylene diamine (C₂H₈N₂), ethylene diamine tetra acetic acid (EDTA), ammonia (NH₃), family of mono, di and tri carboxylic acids like citric acid (C₆H₈O₇), phthalic acid (C₆H₄(COOH)₂), oxalic acid (C₂H₂O₄), acetic acid (C₂H₄O₂), and succinic acid (C₄H_{b}O₄) and family of amino benzoic acids.

Embodiments of the method of planarizing copper using a slurry containing molybdenum trioxide (MoO₃) may also be provided with a nonionic surfactant, an anionic surfactant, or a cationic surfactant. The anionic surfactant used in the aqueous slurry may comprise any one or a mixture of polyacrylic acid (PAA), a carboxylic acid or its salt, a sulfuric ester or its salt, a sulfonic acid or its salt, a phosphoric acid or its salt, and a sulfosuccinic acid or its salt. The cationic surfactant used in the aqueous slurry may comprise any one or a mixture of a primary amine or its salt, a secondary amine or its salt, a tertiary amine or its salt, and a quaternary amine or its salt. The nonionic surfactant may comprise any one or a mixture of one of many polyethylene glycols.

Still yet other embodiments of the method of planarizing copper using an aqueous slurry may be provided with a copper corrosion inhibitor which may comprise any one or a mixture of heterocyclic organic compounds including benzotriazole (BTA), benzimidazole, poly triazole, phenyl triazole, thion and their derivatives. Further embodiments of slurries may contain any combination of these surfactants and corrosion inhibitors.

Aqueous slurries may optionally include acids or bases for adjusting the pH within an effective range of from about 1 to about 14. Yet additional embodiments of slurries according to the invention may also be provided with supplemental ceramic/metal oxide particles. Such supplemental ceramic/metal oxide particles used in the aqueous slurry may comprise any one or a mixture of silica, ceria, zirconia, titania, magnesia, iron oxide, tin oxide, and germania.

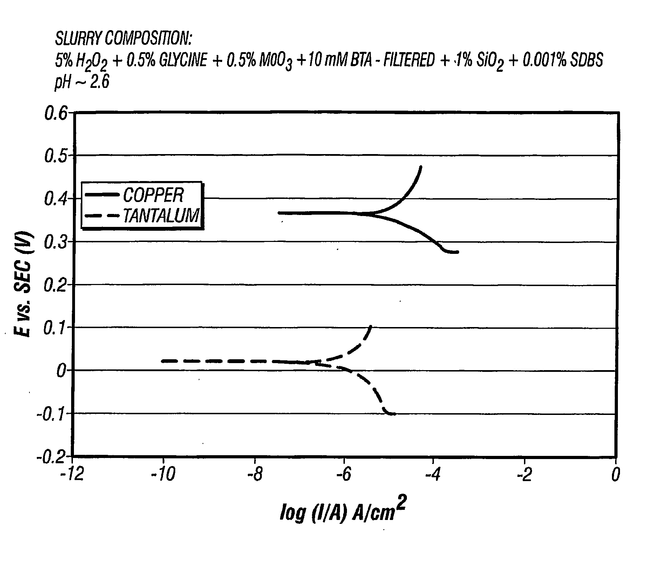

### Brief Description of the Drawing

The figure is a plot of the potentiodynamic polarization curves of copper and tantalum coupons in a slurry containing MoO₃.

### Detailed Description of the Preferred Embodiments

Broadly described, embodiments of aqueous slurries according to the present invention may comprise a molybdenum oxide (MoO₂) polishing material and an oxidizing agent. The MoO₂ polishing material may be present in an amount of about 0.5 to about 10 wt.%, such as about 1 to about 3 wt.%, and more preferably in an amount of about 3 wt.%. The molybdenum oxide polishing material may comprise fine particles of MoO₂ having a mean particle size in the range of about 25 nanometers (nm) to about 1 micron, such as about 25 nanometers to about 560 nm, and more preferably about 50 to 200 nm, as measured by a Horiba laser scattering analyzer.

The MoO₂ particles may be produced from a variety of molybdenum-containing precursor materials, such as, for example, ammonium molybdates and related compounds, as well as molybdenum oxides prepared from a variety of processes known in the art, wherein molybdenum precursors and products can be made into particles within the size ranges specified herein. Alternatively particles of MoO₂ may be reduced in size to the ranges specified herein by any of a variety of milling methods known in the art, such as attrition milling assisted by the use of appropriate reagents.

By way of example, embodiments of slurries according to the present invention may utilize particles of MoO₂ produced from a precursor material comprising nano-particles of MoO₃. Nano-particles of MoO₃ are commercially available from the Climax Molybdenum Company of Ft. Madison, Iowa (US). Alternatively, nano-particles of MoO₃ may be produced in accordance with the teachings provided in U.S. Patent No. 6,468,497 B1, entitled "Method for Producing Nano-Particles of Molybdenum Oxide," which is hereby incorporated herein by reference for all that it discloses.

Regardless of whether the nano-particles of MoO₃ are obtained commercially or manufactured in accordance with the teachings provided in U.S. Patent No. 6,468,497 B1, identified above, the MoO₂ particles comprising the polishing material may be produced by heating nano-particles of MoO₃ for a time sufficient to convert substantially all of the MoO₃ to MoO₂. More specifically, the nano-particles of MoO₃ may be heated in a reducing atmosphere (e.g., hydrogen) to a temperature in the range of about 400°C to about 700°C (550°C preferred). Times may be in the range of about 30 to about 180 minutes, as may be required to reduce MoO₃ to MoO₂ in sufficient quantities. Heating may be accomplished in a rotary furnace, although other types of furnaces may be used. If necessary, the resulting MoO₂ product may then be ground to produce an MoO₂ polishing material having a mean particle diameter within the ranges specified herein. A particle classification step may optionally be used to ensure that the resulting MoO₂ polishing material lacks particles that may cause damage during polishing.

The oxidizing agent may comprise any one or a mixture of ferric nitrate (Fe(NO₃)₃), nitric acid (HNO₃), potassium iodide (KI), and potassium iodate (KIO₃). Ferric nitrate oxidizing agent may be present in concentrations ranging from about 0.05 to about 0.2 molar (M) Fe(NO₃)₃, such as about 0.1 to about 0.2M Fe(NO₃)₃, and more preferably in a concentration of about 0.2 M Fe(NO₃)₃. Nitric acid oxidizing agent may be present in amounts ranging from about 0.5 to about 2 wt.% HNO₃, such as about 1 to about 2 wt.% HNO₃, and more preferably in an amount of about 2 wt.% HNO₃. Potassium iodide oxidizing agent may be present in amounts ranging from about 0.5 to about 5 wt.% KI, such as about 1 to about 5 wt.% KI, and more preferably in an amount of about 3 wt.% KI. Potassium iodate oxidizing agent may be present in amounts ranging from about 1 to about 5 wt. % KIO₃, such as about 1 to about 3 wt. % KIO₃, and more preferably in an amount of about 3 wt. % KIO₃.

Additional oxidizing agents may comprise any one or a mixture of hydroxylamine hydrochloride ((NH₂OH)Cl) and potassium permanganate (KMnO₄). Hydroxylamine hydrochloride oxidizing agent may be present in amounts ranging from about 1 to about 5 wt.% (NH₂OH)Cl, such as about 2 to about 4 wt.% (NH₂OH)Cl, and more preferably in an amount of about 3 wt.% (NH₂OH)Cl. Potassium permanganate oxidizing agent may be present in amounts ranging from about 1 to about 5 wt.% KMnO₄, such as about 2 to about 4 wt.% KMnO₄, and more preferably in an amount of about 3 wt.% KMnO₄. However, the polishing rates with slurries containing hydroxylamine hydrochloride and potassium permanganate are generally lower than with the other oxidizing agents identified herein.

Embodiments of slurries according to the present invention may also be provided with an anionic surfactant or a cationic surfactant. The anionic surfactant used in the aqueous slurry may comprise any one or a mixture of polyacrylic acid (PAA), a carboxylic acid or its salt, a sulfuric ester or its salt, a sulfonic acid or its salt, a phosphoric acid or its salt, and a sulfosuccinic acid or its salt. The cationic surfactant used in the aqueous slurry may comprise any one or a mixture of a primary amine or its salt, a secondary amine or its salt, a tertiary amine or its salt, and a quaternary amine or its salt. Optionally, the aqueous slurry may be provided with a copper corrosion inhibitor which may comprise any one or a mixture of heterocyclic organic compounds including benzotriazole (BTA), triazole, and benzimidazole. Further, the slurry may contain any combination of these surfactants and corrosion inhibitors.

A preferred anionic surfactant is polyacrylic acid (PAA). A preferred cationic surfactant is cetyl pyridinium chloride (CPC). A preferred copper corrosion inhibitor is benzotriazole (BTA). The addition of PAA improved slurry dispersability and surface quality. It is believed that the addition of PAA modifies the surface charge of the molybdenum oxide particles such that interaction between the molybdenum oxide particles and copper is favorable, leading to an increase in the polish rate. Polyacrylic acid (PAA) surfactant may be present in amounts ranging from about 0.1 to about 4 wt.% PAA, such as about 0.5 to about 1 wt.% PAA, and more preferably in an amount of about 1 wt.% PAA. The cationic surfactant cetyl pyridinium chloride (CPC) may be present in amounts ranging from about 0.01 to about 1 wt.% CPC, such as about 0.05 to about 0.5 wt.% CPC, and more preferably in an amount of about 0.1 wt.% CPC. Benzotriazole (BTA) copper corrosion inhibitor may be present in concentrations ranging from about 0.5 to about 10 milli-molar (mM) BTA, such as about 1 to about 5 mM BTA, and more preferably in a concentration of about 1 mM BTA.

Embodiments of slurries according to the present invention may also be provided with amounts of molybdenum sulfide (MoS₂) as a lubricant. It has been found that the addition of molybdenum sulfide particles increases the polish rate of copper for slurries containing KIO₃ and PAA. Molybdenum sulfide particles may have mean diameters in the range of about 0.01 to about 1 micron. Molybdenum sulfide particles may be present in amounts ranging from about 0.1 to about 10 wt.% MoS₂, such as about 0.5 to about 5 wt.% MoS₂, and more preferably in an amount of about 1 wt.% MoS₂. Molybdenum sulfide particles having the size ranges herein are commercially available from the Climax Molybdenum Company of Ft. Madison, Iowa (US).

The pH of embodiments of slurries according to the present invention may be in the range of about 1 to about 14, such as a pH in the range of about 3 to about 7, and preferably having a pH of 4. The pH of embodiments of slurries according to the present invention may be adjusted by the addition of suitable acids (e.g., hydrochloric acid (HCl)) or bases (e.g., potassium hydroxide (KOH)), as would be known by persons having ordinary skill in the art.

Yet additional embodiments of planarizing slurries according to the invention may also be provided with supplemental ceramic/metal oxide particles. Such supplemental ceramic/metal oxide particles used in the aqueous slurry may comprise any one or a mixture of silica, ceria, aluminia, zirconia, titania, magnesia, iron oxide, tin oxide, and germania.

Embodiments of slurries according to the present invention exhibit high polish rates for copper when used in the CMP process. More particularly, when potassium iodate (KIO₃) was used as an oxidizing agent in the molybdenum oxide slurries very high copper disk and copper film polish rates (e.g., up to -1000 and 470 nm/min, respectively, were obtained, as detailed in the following examples. Addition of PAA enhanced the film polish rate to about 667 nm/min. Further, when molybdenum sulfide particles were added to slurries containing KIO₃ and PAA, copper film polish rates of about 750 nm/min were obtained.

While polish rates with the KIO₃-based slurries of the present invention are high for copper, the post-polish surface of the copper tended to be covered with a thick, uneven misty layer with roughness values as high as about 150 nm as measured by a non-contact optical profilometer. If the post-polish surface quality is desired to be higher, the CMP polishing step may be followed by a buffing step. In one embodiment, the buffing step involved additionally polishing the copper surface with a dilute suspension of H₂O₂, glycine, BTA, and colloidal silica in de-ionized water at a pH of 4. The advantage of using an H₂O₂-based buffing step is that H₂O₂ reacts spontaneously with molybdenum oxide, thus removing residual amounts of molybdenum oxide that may remain on the surface. Very clean and smooth copper surfaces were obtained after subsequent buffing, some with roughness values as low as 0.35 nm as measured by a non-contact optical profilometer.

Polishing selectivity of one embodiment of a slurry of the present invention between Cu, Ta, and silicon oxide (SiO₂) was determined to be 235:1:1 for Cu:Ta:SiO₂, as presented in Example 24.

Examples 25 and 26 involve the addition of ethylene diamine tetra acetic acid (EDTA) to test the complexing ability of EDTA with copper ions. The polish rates for the two specified slurry compositions are presented in Table 5.

In order to provide further information regarding the invention, the following examples are provided. The examples presented below are representative only and are not intended to limit the invention in any respect.

### EXAMPLES 1-15

Slurries of examples 1-15 were used to polish a copper disk having a diameter of 1.25 inches. The CMP polisher was a Struers DAP® with an IC-1400, k-groove polishing pad. The carrier remained stationary (i.e., was not rotated). The rotation rate of the platen was 90 revolutions per minute (rpm). The down-force placed on the copper disk was 6.3 pounds per square inch (psi). The slurry flow rate was 60 ml/min. The amount of copper removed from the surface of the disk by CMP was determined by measuring the weight difference of the copper disk both before and after polishing, taking into consideration the density of the Cu material, the area of the disk that was polished, and the polishing time. This was then converted into the rate of removal in terms of nm of copper removed per minute.

The slurries of examples 1-10 all contained 3 wt.% molybdenum oxide (MoO₂) in deionized water. The mean particle size of molybdenum oxide for examples 1-10 was 1 micron (1000 nm). The mean particle size of molybdenum oxide for examples 11-15 was 150 nm. Various amounts and types of oxidizing agents were added, as identified in Table 1. Example 11 contained 1.5 wt.% MoO₂ with 3 wt.% hydroxylamine hydrochloride ((NH₂OH)Cl) as an oxidizing agent. Example 12 contained 1.5 wt.% MoO₂ with 3 wt.% potassium permanganate (KMnO₄) as the oxidizing agent. Examples 13-15 all contain 3 wt.% KIO₃ with varying amounts of MoO₂, as noted. The pH of slurries for examples 1-15 was adjusted to 4.0 by the addition of hydrochloric acid (HCl) or potassium hydroxide (KOH). The slurry compositions and polishing rates for the copper disk are presented in Table 1.

**TABLE 1**

| Example | Slurry Composition | Mean Particle Size (nm) | pH | Polish Rate (nm/min) |
|---|---|---|---|---|
| 1 | 3% MoO₂ + 0.05M Fe(NO₃)₃ | 1000 | 4 | 69 |
| 2 | 3% MoO₂ + 0.1M Fe(NO₃)₃ | 1000 | 4 | 88 |
| 3 | 3% MoO₂ + 0.2M Fe(NO₃)₃ | 1000 | 4 | 230 |
| 4 | 3% MoO₂ + 0.5%HNO₃ | 1000 | 4 | 348 |
| 5 | 3% MoO₂ + 1%HNO₃ | 1000 | 4 | 221 |
| 6 | 3% MoO₂ + 2%HNO₃ | 1000 | 4 | 353 |
| 7 | 3% MoO₂ + 3% KI | 1000 | 4 | 157 |
| 8 | 3% MoO₂ + 1% KIO₃ | 1000 | 4 | 123 |
| 9 | 3% MoO₂ + 2% KIO₃ | 1000 | 4 | 345 |
| 10 | 3% MoO₂ + 3% KIO₃ | 1000 | 4 | 1014 |
| 11 | 1.5% MoO₂ + 3%(NH₂OH)Cl | 150 | 4 | 68 |
| 12 | 1.5% MoO₂ + 3% KMnO₄ | 150 | 4 | 31 |
| 13 | 1% MoO₂ + 3% KIO₃ | 150 | 4 | 169 |
| 14 | 2% MoO₂ + 3% KIO₃ | 150 | 4 | 524 |
| 15 | 3% MoO₂ + 3% KIO₃ | 150 | 4 | 862 |

### EXAMPLES 16-18

Slurries of examples 16-18 were used to polish a copper film deposited on a silicon substrate by sputter deposition. The copper film had a diameter of 6 inches. The CMP polisher was a Westech Model 372 with an IC-1400, k-groove polishing pad. The carrier was rotated at a rate of 40 rpm. The platen was rotated at 40 rpm. The down-force placed on the copper film was 6 pounds per square inch (psi). The slurry flow rate was set at 200 ml/min.

The amount of copper removed from the surface of the silicon substrate by CMP was determined by measuring the sheet resistance of the Cu film both before and after polishing at 17 points spread across the film utilizing a home-made paper mask and a 4-point probe. Sheet resistance was measured at the same points on the film before and after polishing. The measured sheet resistances both before and after polishing were then converted to respective film thicknesses before and after polishing based on the resistivity of the Cu material, the current applied, and the voltage across the 4-point probe. The difference between the starting and final thicknesses as 17 points were calculated, an average thickness loss was obtained which was then divided by the polish time to give the polish rate in nm/min.

The slurries all contained 3 wt.% molybdenum oxide (MoO₂) in deionized water and with a potassium iodate (KIO₃) oxidizing agent present in an amount of 3 wt.%. The mean particle size of the molybdenum oxide for examples 16-18 was 1 micron (1000 nm). Example 17 added 1 wt.% PAA to the slurry. Example 18 added 1 wt.% PAA and 1 wt.% molybdenum sulfide (MoS₂) to the slurry. The pH of the slurries of examples 16-18 was adjusted to 4.0 by the addition of hydrochloric acid (HCl) or potassium hydroxide (KOH). The slurry compositions and polishing rates for the copper film are presented in Table 2.

**TABLE 2**

| Example | Slurry Composition | Mean Particle Size (nm) | pH | Polish Rate (nm/min) |
|---|---|---|---|---|
| 16 | 3% MoO₂ + 3% KIO₃ | 1000 | 4 | 471 |
| 17 | 3% MoO₂ + 3% KIO₃ + 1% PAA | 1000 | 4 | 667 |
| 18 | 3% MoO₂ + 3% KIO₃ + 1% PAA +1% MoS₂ | 1000 | 4 | 750 |

### EXAMPLES 19-23

Slurries of examples 19-23 were used to polish a copper film deposited on a silicon substrate by sputter deposition. The copper film had a diameter of 6 inches. The CMP polisher was a Westech Model 372 with an IC-1400, k-groove polishing pad. The carrier was rotated at a rate of 75 rpm. The platen was also rotated at 75 rpm. The down-force placed on the copper film was 4 pounds per square inch (psi). The slurry flow rate was set at 200 ml/min.

The amount of copper removed from the surface of the silicon substrate by CMP was determined by measuring the sheet resistance of the Cu film both before and after polishing at 17 points spread across the film utilizing a home-made paper mask and a 4-point probe. Sheet resistance was measured at the same points on the film before and after polishing. The measured sheet resistances both before and after polishing were then converted to respective film thicknesses before and after polishing based on the resistivity of the Cu material, the current applied, and the voltage across the 4-point probe. The difference between the starting and final thicknesses as 17 points were calculated, an average thickness loss was obtained which was then divided by the polish time to give the polish rate in nm/min.

The slurries all contained 3 wt.% molybdenum oxide (MoO₂) in deionized water and with a potassium iodate (KIO₃) oxidizing agent present in an amount of 3 wt.%. The mean particle diameter of the molybdenum oxide for examples 19-23 was 150 nm. Example 20 added 1 mM benzotriazole (BTA) to the slurry. Example 21 added 1 wt.% polyacrylic acid (PAA) to the slurry. Example 22 added 0.1 wt.% cetyl pyridinium chloride (CPC) to the slurry. Example 23 added 2 wt.% PAA and 1 mM BTA to the slurry. The pH of the slurries of examples 19-23 was adjusted to 4.0 by the addition of hydrochloric acid (HCl) or potassium hydroxide (KOH). The slurry compositions and polishing rates for the copper film are presented in Table 3.

**TABLE 3**

| Example | Slurry Composition | Mean Particle Size (nm) | pH | Polish Rate (nm/min) |
|---|---|---|---|---|
| 19 | 3% MoO₂ + 3% KIO₃ | 150 | 4 | 695 |
| 20 | 3% MoO₂ + 3% KIO₃ + 1mM BTA | 150 | 4 | 471 |
| 21 | 3% MoO₂ + 3% KIO₃ + 1% PAA | 150 | 4 | 997 |
| 22 | 3% MoO₂ + 3% KIO₃ + 0.1% CPC | 150 | 4 | 913 |
| 23 | 3% MoO₂ + 3% KIO₃ + 2% PAA + 1mM BTA | 150 | 4 | 660 |

### EXAMPLE 24

Silicon wafers (6 inch diameter) having a 0.3 micron Ta layer deposited by sputter deposition and wafers having a 1 micron SiO₂ layer applied by thermal oxidation were separately polished with a polishing slurry. The amount of copper and Ta removed was determined using a four-point probe, and SiO₂ removed from the surface of the silicon wafer by CMP was measured using an optical interferometer, in order to determine the rate of removal in terms of nm of material removed per minute.

The slurry utilized comprised 3 wt% molybdenum oxide (moO₂) in deionized water with potassium iodate (KIO₃) oxidizing agent present in an amount of 3 wt.%. The mean particle size of the molybdenum oxide for example 24 was 1 micron (1000 nm). The CMP polisher was a Westech Model 372 with an IC-1400, k-groove polishing pad. The carrier was rotated at a rate of 40 rpm. The platen was also rotated at 40 rpm. The down-force placed on the copper film was 6 pounds per square inch (psi). The slurry flow rate was 200 ml/min. The slurry composition and polishing rates for Cu, Ta, and SiO₂ are presented in Table 4.

**TABLE 4**

| Example | Slurry Composition | Cu Polish Rate (nm/min) | Ta Polish Rate (nm/min) | SiO₂ Polish Rate (nm/min) |
|---|---|---|---|---|
| 24 | 3% MoO₂ + 3% KIO₃ | 471 | 2 | 2 |

### EXAMPLES 25 and 26

Slurries of examples 25 and 26 were used to polish a copper disk having a diameter of 1.25 inches. The CMP polisher was a Struers DAP® with an IC-1400, k-groove polishing pad. The carrier remained stationary (i.e., was not rotated). The rotation rate of the platen was 90 revolutions per minute (rpm). The down-force placed on the copper disk was 6.3 pounds per square inch (psi). The slurry flow rate was 60 ml/min. The amount of copper removed from the surface of the disk by CMP was determined by measuring the weight difference of the copper disk both before and after polishing, taking into consideration the density of the Cu material, the area of the disk that was polished, and the polishing time. This was then converted into the rate of removal in terms of nm of copper removed per minute.

The slurries of examples 25 and 26 all contained 3 wt.% molybdenum oxide (MoO₂) in deionized water. The mean particle size of molybdenum oxide for both examples 25 and 26 was 1 micron (1000 nm). Various amounts and types of oxidizing agents were added, as identified in Table 5. Slurries of both examples included the addition of 1 wt.% ethylene diamine tetra acetic acid (EDTA) to test the complexing ability of EDTA with copper ions. The slurry compositions and polishing rates for the copper disk are presented in Table 5.

**TABLE 5**

| Example | Slurry Composition | Mean Particle Size (nm) | pH | Polish Rate (nm/min) |
|---|---|---|---|---|
| 25 | 3%MoO₂ + 3% KI + 1% EDTA | 1000 | 4 | 146 |
| 26 | 3%MoO₂ + 3% KI + 1% KMnO₄ + 1% EDTA | 1000 | 4 | 259 |

Another embodiment of an aqueous slurry may comprise molybdenum trioxide (MoO₃) and an oxidizing agent. The MoO₃ may be present in an amount of about 0.1 to about 10 wt. %, such as about 0.5 to about 10 wt. %, and more preferably in an amount of about 0.5 to about 5 wt. %. The molybdenum trioxide (MoO₃) may be provided in powder form such that the molybdenum trioxide (MoO₃) visibly dissolves or substantially visibly dissolves in the oxidizing agent. The molybdenum trioxide power may have a mean particle size of about 10,000 nm (10 microns) and more preferably less than about 1,000 nm (1 micron), as measured by a Horiba laser scattering analyzer. Generally speaking molybdenum trioxide (MoO₃) powders having these sizes are visibly dissolved in an aqueous solution of deionized water and the oxidizing agent. As used herein, the terms "dissolved" and "visibly dissolved," refer to solutions wherein the particles of MoO₃ are at least partially, although not necessarily completely, dissolved. Stated another way, solutions containing particles of MoO₃ may appear substantially clear or "visibly dissolved" to the naked eye, even though the particles of MoO₃ may not be completely dissolved.

An alternative embodiment of an aqueous slurry may comprise molybdic acid. The dissolution of molybdenum trioxide in an aqueous solution of deionized water and an oxidizing agent may form molybdic acid. In addition, molybdic acid may be formed by dissolving molybdenum metal, molybdenum oxides, or molybdates in an oxidizing medium. The term "molybdic acid" as used herein refers to any compound containing molybdenum and capable of transferring a hydrogen ion in solution. Embodiments of the aqueous slurry of the present invention utilizing molybdic acid may comprise the same oxidizing agents, complexing agents, surfactants, corrosion inhibitors, acids or bases, and supplemental ceramic/metal oxide particles as are listed below for the molybdenum trioxide aqueous slurry.

The MoO₃ particles may be produced from a variety of molybdenum-containing precursor materials, such as, for example, ammonium molybdates and related compounds, as well as molybdenum oxides prepared from a variety of processes known in the art, wherein molybdenum precursors and products can be made into particles of varying sizes. Molybdenum trioxide particles suitable for use in the present invention are commercially available from a wide variety of sources, including the Climax Molybdenum Company of Ft. Madison, Iowa (US).

The oxidizing agent used with molybdenum trioxide (MoO₃) may comprise any one or a mixture of hydrogen peroxide (H₂O₂), ferric nitrate (Fe(NO₃)₃), potassium iodate (KIO₃), nitric acid (HNO₃), potassium permanganate (KMnO₄), potassium persulfate (K₂S₂O₈), ammonium persulfate ((NH₄)₂S₂O₈), potassium periodate (KIO₄), and hydroxylamine (NH₂OH). Hydrogen Peroxide oxidizing agent may be present in concentrations ranging from about 0.5 to about 20 wt% H₂O₂, such as about 1 to about 10 wt% H₂O₂, and more preferably in a concentration of about 5 wt% H₂O₂. Ferric Nitrate oxidizing agent may be present in concentrations ranging from about 0.05 to about 0.2 molar (M) Fe(NO₃)₃, such as about 0.1 to about 0.2 M Fe(NO₃)₃, and more preferably in a concentration of about 0.2 M Fe(NO₃)_{3.} Potassium Iodate oxidizing agent may be present in concentrations ranging from about 1 to about 5 wt% KIO₃, such as about 1 to about 3 wt% KIO₃, and more preferably in a concentration of about 3 wt% KIO₃, Nitric Acid oxidizing agent may be present in concentrations ranging from about 0.5 to about 2 wt% HNO₃, such as about 1 to about 2 wt% HNO₃, and more preferably in a concentration of about 2 wt% HNO₃. Potassium Permanganate oxidizing agent may be present in concentrations ranging from about 1 to about 5 wt% KMnO₄, such as about 2 to about 4 wt% KMnO₄, and more preferably in a concentration of about 3 wt% KMnO₄. Potassium Persulfate oxidizing agent may be present in concentrations ranging from about 1 to about 5 wt% K₂S₂O₈, such as about 2 to about 4 wt% K₂S₂O₈, and more preferably in a concentration of about 3 wt% K₂S₂O₈. Ammonium Persulfate oxidizing agent may be present in concentrations ranging from about 1 to about 5 wt% (NH₄)₂S₂O₈, such as about 2 to about 4 wt% (NH₄)₂S₂O₈, and more preferably in a concentration of about 3 wt% (NH₄)₂S₂O₈. Potassium Periodate oxidizing agent may be present in concentrations ranging from about 1 to about 5wt%-KIO₄, such as about 2 to about 4 wt% KIO₄, and more preferably in a concentration of about 3 wt% KIO_{4.} Hydroxylamine oxidizing agent may be present in concentrations ranging from about 1 to about 5 wt% NH₂OH, such as about 2 to about 4 wt% NH₂OH, and more preferably in a concentration of about 3 wt% NH₂OH.

Additionally, complexing agents may be used in the molybdenum trioxide (MoO₃) aqueous slurry. Complexing agents may comprise any one or a mixture of glycine (C₂H₅NO₂), alanine (C₃H₇NO₂), amino butyric acids (C₄H₉NO₂), ethylene diamine (C₂H₈N₂), ethylene diamine tetra acetic acid (EDTA), ammonia (NH₃), family of mono, di, and tri-carboxylic acids like citric acid (C₆H₈O₇), phthalic acid (C₆H₄(COOH)₂), oxalic acid (C₂H₂O₄), acetic acid (C₂H₄O₂), and succinic acid (C₄H₆O₄) and family of amino benzoic acids (C₇H₇NO₂).

Glycine complexing agent may be present in amounts ranging from about 0.1 to about 5 wt.% C₂H₅NO₂, such as about 0.1 to about 3 wt.% C₂H₅NO₂, and more preferably in an amount of about 0.5 wt.% C₂H₅NO₂. Alanine complexing agent may be present in amounts ranging from about 0.1 to about 5 wt.% C₃H₇NO₂, such as about 0.1 to about 3 wt.% C₃H₇NO₂, and more preferably in an amount of about 0.5 wt.% C₃H₇NO₂. Amino butyric acid complexing agent may be present in amounts ranging from about 0.1 to about 5 wt.% C₄H₉NO₂, such as about 0.1 to about 3 wt.% C₄H₉NO₂, and more preferably in an amount of about 0.5 wt.% C₄H₉NO₂. Ethylene diamine complexing agent may be present in amounts ranging from about 0.1 to about 5 wt.% C₂H₈N₂, such as about 0.1 to about 3 wt.% C₂H₈N₂, and more preferably in an amount of about 0.5 wt.% C₂H₈N₂. Ethylene diamine tetra acetic acid complexing agent may be present in amounts ranging from about 0.1 to about 5 wt.% EDTA, such as about 0.1 to about 3 wt.% EDTA, and more preferably in an amount of about 0.5 wt.% EDTA. Ammonia complexing agent may be present in amounts ranging from about 0.1 to about 5 wt.% NH₃, such as about 0.1 to about 3 wt.% NH₃, and more preferably in an amount of about 0.5 wt.% NH₃. Citric acid complexing agent may be present in amounts ranging from about 0.1 to about 5 wt% C₆H₈O₇ such as about 0.1 to about 3 wt.% C₆H₈O₇, and more preferably in an amount of about 0.5 wt.% C₆H₈O₇. Phthalic acid complexing agent may be present in amounts ranging from about 0.1 to about 5 wt.% C₆H₄(COOH)₂ such as about 0.1 to about 3 wt.% C₆H₄(COOH)₂, and more preferably in an amount of about 0.5 wt.% C₆H₄(COOH)₂. Oxalic acid complexing agent may be present in amounts ranging from about 0.1 to about 5 wt.% C₂H₂O₄ such as about 0.1 to about 3 wt.% C₂H₂O₄, and more preferably in an amount of about 0.5 wt.% C₂H₂O₄. Acetic acid complexing agent may be present in amounts ranging.from about 0.1 to about 5 wt.% C₂H₄O₂ such as about 0.1 to about 3 wt.% C₂H₄O₂, and more preferably in an amount of about 0.5 wt.% C₂H₄O₂. Succinic acid complexing agent may be present in amounts ranging from about 0.1 to about 5 wt.% C₄H₆O₄ such as about 0.1 to about 3 wt.% C₄H₆O₄, and more preferably in an amount of about 0.5 wt.% C₄H₆O₄. Amino benzoic acids as a complexing agent may be present in amounts ranging from about 0.1 to about 5 wt.% C₇H₇NO₂ such as about 0.1 to about 3 wt.% C₇H₇NO₂, and more preferably in an amount of about 0.5 wt.% C₇H₇NO_{2.}

Embodiments of slurries containing molybdenum trioxide (MoO₃) may also be provided with a nonionic surfactant, an anionic surfactant, or a cationic surfactant. The anionic surfactant used in the aqueous slurry may comprise any one or a mixture of polyacrylic acid (PAA), a carboxylic acid or its salt, a sulfuric ester or its salt, a sulfonic acid or its salt, a phosphoric acid or its salt, and a sulfosuccinic acid or its salt. The cationic surfactant used in the aqueous slurry may comprise any one or a mixture of a primary amine or its salt, a secondary amine or its salt, a tertiary amine or its salt, and a quaternary amine or its salt. The nonionic surfactant may be one or a mixture of one of the family of polyethylene glycols.

Optionally, the molybdenum trioxide (MoO₃) aqueous slurry may also be provided with a copper corrosion inhibitor which may comprise any one or a mixture of heterocyclic organic compounds including benzotriazole (BTA), benzimidazole, poly triazole, phenyl triazole, thion and their derivatives. Further, the slurry may contain any combination of these surfactants and corrosion inhibitors.

A preferred anionic surfactant used in the MoO₃ slurry is a salt of dodecyl benzene sulfonic acid. The addition of a small amount of the dodecyl benzene sulfonic acid (DBSA) anionic surfactant to the slurry drastically reduced copper coupon dissolution rates to about 0 nm/minute and blanket copper wafer polish rates of about 750 nm/minute were obtained. See Example 34. This low copper coupon dissolution rate indicates low dishing of copper lines during pattern wafer polishing. Dodecyl benzene sulfonic acid surfactant and salts thereof (DBSA) may be present in amounts ranging from about 0.00001 to about 1 wt.% (DBSA), such as about 0.0001 to about 0.5 wt.% (DBSA), and more preferably in an amount of about 0.001 wt.% (DBSA).

A preferred copper corrosion inhibitor used in the MoO₃ slurry is benzotriazole (BTA). The addition of BTA to the slurry brought down the dissolution rates drastically, to less than 50 nm/minute. See Examples 30 - 33. Benzotriazole (BTA) copper corrosion inhibitor may be present in concentrations ranging from about 1 to about 20 milli-molar (mM) BTA, such as about 1 to about 10 mM BTA, and more preferably in a concentration of about 10 mM BTA.

The pH of embodiments of MoO₃ slurries according to the present invention may be in the range of about 1 to about 14, such as a pH in the range of about 1 to about 5, and preferably having a pH of about 2.6. The pH of embodiments of slurries according to the present invention may be adjusted by the addition of suitable acids (e.g., acetic acid) or bases (e.g., potassium hydroxide), as would be known by persons having ordinary skill in the art.

Yet additional embodiments of MoO₃ polishing slurries according to the invention may also be provided with supplemental ceramic/metal oxide particles. Such supplemental ceramic/metal oxide particles used in the aqueous slurry may comprise any one or a mixture of silica, ceria, zirconia, titania, magnesia, iron oxide, tin oxide, and germania. A preferred supplemental ceramic/metal oxide used in the MoO₃ slurry is colloidal silicon dioxide (SiO₂). Colloidal silicon dioxide (SiO₂) may have an average particle size of about 20 nm.

Embodiments of MoO₃ slurries according to the present invention exhibit high polish rates for copper when used in the CMP process. More particularly, when molybdenum trioxide MoO₃ particles were dispersed and dissolved in an aqueous solution containing hydrogen peroxide and glycine and used as a copper CMP slurry, high disk polish rates (e.g., about 2150 nm/minute) were obtained. However, the copper coupon dissolution rates in this slurry were also high (e.g., about 1150 nm/minute). See Example 28. These high dissolution and disk polish rates indicate the active chemical nature of the slurry chemicals. One of the reasons why this slurry exhibits such a high chemical reactivity is due to the partial dissolution of the molybdenum trioxide MoO₃ nano-particles, which form molybdic acid. The copper dissolution rate gives an indication of the rate at which copper would be removed in those regions of the wafer that are not subject to mechanical abrasion. With proper choice of the concentrations of the additives and by inclusion of a corrosion inhibitor, polish rates can be tuned according to a user's requirements and dissolution rates can be minimized.

As shown in Examples 29 & 30, blanket copper wafer polishing rates of one embodiment of an MoO₃ slurry of the present invention were determined to be as high as about 1200 nm/minute with post CMP surface roughness of about 1 nm. The slurries of Examples 29 & 30 were filtered to remove particles above 1,000 nm (1 micron) in size and 1.0 wt % of 20 nm colloidal SiO₂ abrasives were added.

The post-polish surface of the copper was good with post CMP surface roughness values of about 1 nm as measured by a non-contact optical profilometer. If higher post-polish surface quality is desired, the CMP polishing step may be followed by a buffing step. In one embodiment, the buffing step may involve additionally polishing the copper surface with deionized water for about five to about fifteen seconds at a pH in the range of about 5 to about 7. The advantage of using a deionized water rinse buffing step is the removal of reactive chemicals from the wafer-pad interface, which removes residual amounts of molybdenum oxide that may remain on the surface of the wafer-pad. Clean and smooth copper surfaces were obtained after subsequent buffing using a deionized water rinse, some with roughness values as low as about 0.5 to 0.6 nm as measured by a non-contact optical profilometer.

With proper adjustment of the concentrations of the chemicals added and with a deionized water rinse for about five seconds at the end of the wafer polishing, very high polish rates (e.g., about 900 nm/minute) and very low post CMP roughness (e.g., about 0.5 to 0.6 nm) were obtained. Copper coupon dissolution rate in this slurry was low (e.g., about 40 nm/minute). When a small amount of an anionic surfactant, such as sodium dodecyl benzene sulfonate (SDBS), was added to the MoO₃ polishing slurry, copper coupon dissolution rates became about 0 nm/minute, indicating low dishing of copper lines during pattern wafer polishing, and blanket copper wafer polish rates of about 750 nm/minute were obtained. See Example 34.

The general methodology for pattern wafer copper polishing is to polish the bulk copper initially at a high polish rate and then, as planarization is achieved, the copper polish rate is reduced in order to minimize dishing of copper lines. With proper adjustment of the slurry constituent composition and process parameters, the slurry of the present invention can be tuned for this general methodology of polishing at higher rates and then lower rates.

### EXAMPLES 27 & 28

Slurries of examples 27 and 28 were used to polish a copper disk having a diameter of 32 millimeters (mm). The CMP polisher was a Struers DAP® with an IC-1400, k-groove polishing pad. The carrier remained stationary (i.e., was not rotated). The rotation rate of the platen was 90 revolutions per minute (rpm). The down-force placed on the copper disk was 6.3 pounds per square inch (psi). The slurry flow rate was 60 ml/min. The amount of copper removed from the surface of the disk by CMP was determined by measuring the weight difference of the copper disk both before and after polishing, taking into consideration the density of the copper material, the area of the disk that was polished, and the polishing time. This was then converted into the rate of removal in terms of nm of copper removed per minute.

Copper coupon dissolution experiments were performed in a 500 ml. glass beaker containing 400 ml. of the chemical solution. A copper coupon (i.e. 99.99% pure) of dimensions 25 x 25 x 1 mm was used as the experimental sample. The copper coupon was hand polished with 1500 grit sandpaper, washed with dilute hydrochloric acid (HCl) to remove copper oxides from the surface, dried in an air stream, and then weighed. The copper coupon was then immersed in the solution for three minutes while continuously stirring the solution. After the experiment, the copper coupon was washed repeatedly with a deionized water rinse, dried in an air stream, and weighed. Weight loss was used to calculate the dissolution rate.

Example 27 contained 1.0 wt.% MoO₃ in deionized (DI) water and Example 28 contained 1.0 wt. % MoO₃ in deionized (DI) water with 5.0 % H₂O₂ and 1.0 % glycine as an oxidizing agent and complexing agent, respectively. The natural pH of the Example 27 slurry was about 1.8. The natural pH of the Example 28 slurry was about 2.6. The remaining percentages not specified in the below table for the slurry compositions is the percentage of deionized water. In Example 27, the MoO₃ comprises 1% of the slurry composition and the deionized water comprises the remaining 99% of the slurry composition. The slurry compositions, copper coupon dissolution rates and polishing rates for the copper disk of Examples 27 and 28 are presented in Table 6.

**TABLE 6**

| **Example** | **Slurry Composition** | **pH** | **Polish Rate (nm/min)** | **Dissolution Rate (nm/min)** |
|---|---|---|---|---|
| 27 | 1.0 % MoO₃ in DI water | 1.8 | 60 | 20 |
| 28 | 1.0 % MoO₃ + 5.0 % H₂O₂ + 1.0 % glycine in DI water | 2.6 | 2150 | 1140 |

### EXAMPLES 29 - 34

Slurries of examples 29-34 were used to polish a copper film deposited on a silicon substrate by sputter deposition. The copper film had a diameter of 6 inches. The CMP polisher was a Westech Model 372 with an IC-1400, k-groove polishing pad. The carrier was rotated at a rate of 75 rpm. The platen was rotated at 75 rpm. The down-force placed on the copper film was 4 pounds per square inch (psi). The slurry flow rate was set at 200 ml/min.

The amount of copper removed from the surface of the silicon substrate by CMP was determined by measuring the sheet resistance of the copper film both before and after polishing at 17 points spread across the film utilizing a home-made paper mask and a 4-point probe. Sheet resistance was measured at the same points on the film before and after polishing. The measured sheet resistances both before and after polishing were then converted to respective film thicknesses before and after polishing based on the resistivity of the copper material, the current applied, and the voltage across the 4-point probe. The difference between the starting and final thicknesses as 17 points were calculated, an average thickness loss was obtained which was then divided by the polish time to give the polish rate in nm/min.

Copper coupon dissolution experiments were performed in a 500 ml. glass beaker containing 400 ml. of the chemical solution. A copper coupon (i.e. 99.99% pure) having dimensions of 25 x 25 x 1 mm was used as the experimental sample. The copper coupon was hand polished with 1500 grit sandpaper, washed with dilute hydrochloric acid (HCl) to remove any copper oxide from the surface, dried in an air stream, and then weighed. The copper coupon was then immersed in the solution for three minutes while continuously stirring the solution. After the experiment, the copper coupon was washed repeatedly with a deionized (DI) water rinse, dried in an air stream, and weighed. Weight loss was used to calculate the dissolution rate.

The slurries of Examples 29 - 34 contained 0.5 wt.% molybdenum trioxide (MoO₃) in deionized water. At the end of the wafer polishing a deionized (DI) water rinse was applied for five seconds. Example 29 contained 0.5% MoO₃ + 5.0 % H₂O₂ + 1.0 % glycine + 5 mM BTA - filtered with 100 nm filter + 1.0 % SiO₂. The natural pH of the Example 29 slurry was about 2.9. Example 30 contained 0.5% MoO₃ + 5.0% H₂O₂ + 1.0% glycine + 10 mM BTA - filtered with 100 nm filter + 1.0% SiO₂. The natural pH of the Example 30 slurry was about 2.9. Example 31 contained 0.5% MoO₃ + 5% H₂O₂ + 0.5 % glycine + 10 mM BTA - filtered with 100 nm filter + 0.1% SiO₂. The natural pH of the Example 31 slurry was about 2.6. Example 32 contained 0.5% MoO₃ + 5% H₂O₂ + 0.5 % glycine + 10 mM BTA - filtered with 100 nm filter + 0.5% SiO₂. The natural pH of the Example 32 slurry was 2.6. Example 33 contained 0.5% MoO₃ + 5% H₂O₂ + 0.5 % glycine + 10 mM BTA - filtered with 100 nm filter + 1.0 % SiO₂. The natural pH of the Example 33 slurry was about 2.6. Example 34 contained 0.5% MoO₃ + 5% H₂O₂ + 0.5 % glycine + 10 mM BTA + 0.001% SDBS - filtered with 100 nm filter + 1.0 % SiO₂. The natural pH for the slurry of Example 34 was about 2.6. The average size of the particles of SiO₂ in the slurries of Examples 29 - 34 was about 20 nm. The remaining percentages not specified in the below table for the slurry compositions is the percentage of deionized water in the slurry. The slurry compositions and polishing rates for the copper wafer along with the copper coupon dissolution rates for Examples 29 - 34 are presented in Table 7.

**TABLE 7**

| **Example** | **Slurry Composition** | **Mean Particle Size of SiO₂ (nm)** | **pH** | **Polish Rate (nm/min)** | **Dissolution Rate (nm/min)** |
|---|---|---|---|---|---|
| 29 | 0.5% MoO₃ + 5.0 % H₂O₂ + 1.0 % glycine + 5 mM BTA - filtered 1.0 % SiO₂ | 20 | 2.9 | 1250 | 70 |
| 30 | 0.5% MoO₃ + 5.0% H₂O₂ + 1.0% glycine + 10 mM BTA - filtered + 1.0% SiO₂ | 20 | 2.9 | 1225 | 40 |
| 31 | 0.5% MoO₃ + 5% H₂O₂ + 0.5 % glycine + 10 mM BTA - filtered + 0.1% SiO₂ | 20 | 2.6 | 600 | 35 |
| 32 | 0.5% MoO₃ + 5% H₂O₂ + 0.5 % glycine + 10 mM BTA - filtered + 0.5% SiO₂ | 20 | 2.6 | 775 | 35 |
| 33 | 0.5% MoO₃ + 5% H₂O₂ + 0.5 % glycine + 10 mM BTA - filtered + 1.0 % SiO₂ | 20 | 2.6 | 925 | 35 |
| 34 | 0.5% M₀O₃ + 5% H₂O₂ + 0.5 % glycine + 10 mM BTA 0.001% SDBS - filtered + 1.0 % SiO₂ | + 20 | 2.6 | 750 | 0 |

### EXAMPLES 35 - 37

Slurries of Examples 35 - 37 were used to polish six inch copper blanket films. The CMP polisher was a Westech 372 Wafer Polisher with an IC-1400, k-groove polishing pad. The rotation rate of the carrier was 75 revolutions per minute (rpm). The rotation rate of the platen was also 75 revolutions per minute (rpm). The down-force placed on the copper blanket film was 4.0 pounds per square inch (psi). The slurry flow rate was 200 ml/min.

The amount of copper removed from the surface of the silicon substrate by CMP was determined by measuring the sheet resistance of the copper film both before and after polishing at 17 points spread across the film utilizing a home-made paper mask and a 4-point probe. Sheet resistance was measured at the same points on the film before and after polishing. The measured sheet resistances both before and after polishing were then converted to respective film thicknesses before and after polishing based on the resistivity of the copper material, the current applied, and the voltage across the 4-point probe. The difference between the starting and final thicknesses as 17 points were calculated, an average thickness loss was obtained which was then divided by the polish time to give the polish rate in nm/min.

Copper coupon dissolution experiments were performed in a 500 ml. glass beaker containing 400 ml. of the chemical solution. A copper coupon (i.e. 99.99% pure) having dimensions of 25 x 25 x 1 mm was used as the experimental sample. The copper coupon was hand polished with 1500 grit sandpaper, washed with dilute hydrochloric acid (HCl) to remove copper oxides from the surface, dried in an air stream and weighed. The copper coupon was then immersed in the solution for three minutes while continuously stirring the solution. After the experiment, the copper coupon was washed repeatedly with deionized (DI) water, dried in an air stream, and weighed. Weight loss was used to calculate the dissolution rate.

Example 35 contained 1% MoO₃ + 5.0 % H₂O₂ + 1.0 % glycine + 5 mM BTA - filtered with 100 nm filter + 1.0 % SiO₂. The natural pH of the Example 35 slurry was about 2.6. Example 36 contained 1% MoO₃ + 5.0 % H₂O₂ + 1.0 % glycine + 10 mM BTA - filtered with 100 nm filter + 1.0 % SiO₂. The natural pH of the Example 36 slurry was about 2.6. Example 37 contained 1% MoO₃ + 5.0 % H₂O₂ + 1.0 % glycine + 15 mM BTA - filtered with 100 nm filter + 1.0 % SiO₂. The natural pH of the Example 37 slurry was about 2.6. The remaining percentages not specified in the below table for the slurry compositions is the percentage of deionized water in the slurry. The slurry compositions and polishing rates for the copper wafer along with the copper coupon dissolution rates for Examples 35-37 are presented in Table 8.

**TABLE 8**

| **Example** | **Slurry Composition** | **Mean Particle Size of SiO₂ (nm)** | **pH** | **Polish Rate (nm/min)** | **Dissolution Rate (nm/min)** |
|---|---|---|---|---|---|
| 35 | 1 % MoO₃ + 5.0% H₂O₂ + 1.0% glycine + 5 mM BTA - filtered + 1.0% SiO₂ | 20 | 2.6 | 1230 | 55 |
| 36 | 1 % MoO₃ + 5.0% H₂O₂ + 1.0% glycine + 10 mM BTA - filtered + 1.0% SiO₂ | 20 | 2.6 | 1120 | 50 |
| 37 | 1% MoO₃ +5.0% H₂O₂ + 1.0% glycine + 15 mM BTA - filtered + 1.0% SiO₂ | 20 | 2.6 | 760 | 35 |

As shown by the potentiodynamic polarization curves in the figure, open circuit potential of a copper coupon in the MoO₃ slurry was noble to that of a tantalum coupon indicating that galvanic corrosion of copper will not be a problem during pattern wafer polishing which will minimize the dishing of copper lines. The details of the experimental procedure in obtaining these results are as follows. EG&G model 273A Potentiostat/Galvanostat was used to perform potentiodynamic polarization experiments. A three-electrode configuration consisting of a working electrode (Cu/Ta coupon), platinum counter electrode, and a saturated calomel electrode (SCE) as a reference electrode was used. The three electrodes are immersed in a 250 ml of the chemical solution and the potential of the working electrode was scanned from -750 mV to about 1000 mV w.r.t. open circuit potential (OCP) and the resulting current density was monitored using a EG&G Princeton Applied Research model 352 softcorr TM II corrosion software.

The general method for pattern wafer polishing is to polish the bulk copper initially at a high rate and as planarization is achieved, the copper is removed at a lower rate in order to minimize dishing of copper lines. With proper adjustment of the MoO₃ slurry constituent composition and process parameters, the MoO₃ slurry of the present invention may be tuned for this general method of polishing at a higher rate and then a lower rate. Tantalum dissolution and disk polish rates with the same MoO₃ slurry were both less than 5 nm/minute. High copper blanket wafer removal rates, high selectivity to tantalum, good post CMP surface finish and low abrasive content, leading to a reduced number of post CMP defects and easier post CMP cleaning, make this slurry an attractive candidate for the first step of copper CMP process.

In conclusion, the claimed product and process collectively represent an important development in CMP technology. The product and process discussed above are novel, distinctive, and highly beneficial from a technical and utilitarian standpoint. Having herein set forth preferred embodiments of the present invention, it is anticipated that suitable modifications can be made thereto which will nonetheless remain within the scope of the invention. The invention shall therefore only be construed in accordance with the following claims:

## Claims

1. A method for chemical-mechanical planarization of a copper layer, comprising:
providing an aqueous slurry comprising particles of MoO₂ having a mean particle size in a range from 100 nm to 1000 nm in a solution of deionized water and an oxidizing agent; and
polishing the copper layer using the aqueous slurry and a polishing pad.

2. The method of claim 1, wherein the particles of MoO₂ are present in the aqueous slurry in an amount ranging from 0.5 wt. % to 10 wt. %.

3. The method of claim 2, wherein the particles of MoO₂ are present in the aqueous slurry in an amount ranging from 1 wt. % to 3 wt. %.

4. The method of claim 1, wherein providing the aqueous slurry comprises selecting the oxidizing agent from one or more of the group consisting of ferric nitrate, nitric acid, potassium iodide, and potassium iodate.

5. The method of claim 1, wherein the oxidizing agent lacks sufficient H₂O₂ to react spontaneously with the particles of MoO₂.

6. The method of claim 1, wherein the providing the aqueous slurry comprises adding an anionic surfactant to the aqueous slurry, the anionic surfactant comprising one or more selected from the group consisting of polyacrylic acid, a carbolic acid or its salt, a sulfuric ester or its salt, a sulfonic acid or its salt, a phosphoric acid or its salt, and a sulfosuccinic acid or its salt.

7. The method of claim 1, wherein the providing the aqueous slurry comprises adding a cationic surfactant to the aqueous slurry, the cationic surfactant comprising one or more selected from the group consisting of a primary amine or its salt, a secondary amine or its salt, a tertiary amine or its salt, and a quaternary amine or its salt.

8. A method for chemical-mechanical planarization of a copper layer, comprising:
providing a solution of deionized water and an oxidizing agent;
forming an aqueous slurry by adding particles of MoO₃ to the solution until the particles are visibly dissolved making an MoO₃ solution, the particles of MoO₃ having a mean particle size of between 1000 nm and 10,000 nm; and
polishing the copper layer with the aqueous slurry and a polishing pad.

9. The method of claim 8, wherein the forming an aqueous slurry comprises filtering the MoO₃ solution, making a filtered solution.

10. The method of claim 9, wherein the filtering the MoO₃ solution comprises removing from the MoO₃ solution undissolved particles of MoO₃ larger than 1000 nm.

11. The method of claim 9, wherein the filtering the MoO₃ solution comprises removing from the MoO₃ solution undissolved particles of MoO₃ larger than 100 nm.

12. The method of claim 8, wherein the forming an aqueous slurry comprises adding supplemental ceramic/metal oxide particles to the filtered solution.

13. A method for polishing copper by chemical mechanical planarization, comprising:
preparing a high polish rate slurry comprising dissolved particles of MoO₃ and an oxidizing agent;
polishing the copper with a high polish rate slurry;
preparing a low polish rate slurry comprising dissolved particles of MoO₃, an oxidizing agent and a copper corrosion inhibitor; and
polishing the copper with a low polish rate slurry.

14. The method of claim 13, wherein the polishing the copper with the low polish rate slurry occurs after polishing the copper with the high polish rate slurry.
